(19) **Europäisches Patentamt / European Patent Office / Office européen des brevets**

(11) **EP 3 324 197 B1**

(12) **FASCICULE DE BREVET EUROPEEN**

(45) Date de publication et mention de la délivrance du brevet:
**12.12.2018 Bulletin 2018/50**

(51) Int Cl.:
***G01R 31/36*** (2006.01)

(21) Numéro de dépôt: **17198759.7**

(22) Date de dépôt: **27.10.2017**

(54) **PROCÉDÉ DE DÉTERMINATION DE L'ÉTAT DE SANTÉ D'UNE CELLULE DE BATTERIE**

VERFAHREN ZUR BESTIMMUNG DES ZUSTANDS EINER BATTERIEZELLE

METHOD FOR DETERMINING THE STATE OF HEALTH OF A BATTERY CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.11.2016 FR 1661336**

(43) Date de publication de la demande:
**23.05.2018 Bulletin 2018/21**

(73) Titulaire: **Commissariat à l'Energie Atomique et aux Energies Alternatives
75015 Paris (FR)**

(72) Inventeur: **KAROUI HENCHIRI, Fathia
73000 CHAMBERY (FR)**

(74) Mandataire: **Cabinet Beaumont
4, Place Robert Schuman
B.P. 1529
38025 Grenoble Cedex 1 (FR)**

(56) Documents cités:
**EP-A2- 1 263 111        FR-A1- 2 977 678
FR-A1- 3 011 393         JP-A- 2001 257 008
US-A1- 2001 022 518      US-A1- 2008 150 491**

- **EDDAHECH AKRAM ET AL: "Determination of lithium-ion battery state-of-health based on constant-voltage charge phase", JOURNAL OF POWER SOURCES, vol. 258, 15 juin 2014 (2014-06-15), pages 218-227, XP028604616, ISSN: 0378-7753, DOI: 10.1016/J.JPOWSOUR.2014.02.020**

**Description**

<u>Domaine</u>

La présente demande concerne le domaine des batteries électriques de façon générale, et vise plus particulièrement la détermination de l'état de santé ou état de vieillissement d'une cellule d'une batterie.

<u>Exposé de l'art antérieur</u>

Une batterie électrique est un groupement de plusieurs cellules rechargeables (accumulateurs, etc.) reliées en série et/ou en parallèle entre deux noeuds ou bornes de fourniture de tension.

Une batterie comprend en outre classiquement un dispositif électronique de gestion, généralement appelé BMS (de l'anglais "Battery Management System" - Système de gestion de batterie), relié aux cellules de la batterie, qui peut mettre en oeuvre des fonctions diverses telles que des fonctions d'équilibrage des cellules, des fonctions de protection, etc.

Dans certaines batteries, le dispositif de gestion gère des jauges ou indicateurs lui permettant de connaître à tout instant l'état de charge, aussi appelé SOC (de l'anglais "State of Charge") de chaque cellule de la batterie, c'est-à-dire le rapport entre la quantité de charges contenue dans la cellule et la capacité totale de la cellule.

Le dispositif de gestion peut en outre gérer un indicateur complémentaire représentatif du vieillissement des cellules, généralement appelé SOH, de l'anglais "State of Health" pour état de santé. A un instant donné de la vie d'une cellule, le SOH est égal au rapport de la capacité totale de la cellule à l'instant considéré sur la capacité totale de la cellule à l'état neuf ou sur la capacité nominale de la cellule. La connaissance du SOH de chaque cellule peut par exemple permettre d'identifier des cellules défectueuses pour les isoler ou les remplacer, ou de recaler ou réajuster les jauges d'état de charge des cellules pour tenir compte du vieillissement des cellules, de façon à leur permettre de continuer à fournir une estimation fiable.

Les techniques connues de détermination du SOH d'une cellule passent généralement par une mesure de la capacité de cette cellule. Pour cela, la cellule peut être complètement déchargée puis complètement rechargée, ou complètement rechargée puis complètement déchargée. Lors de la recharge complète ou de décharge complète, la quantité de charges accumulée dans la cellule ou extraite de la cellule peut être mesurée par comptage coulométrique, ce qui revient à mesurer la capacité réelle de la cellule. Connaissant la capacité réelle de la cellule, le dispositif de gestion peut ensuite calculer le SOH de la cellule en divisant cette capacité réelle par la capacité de la cellule à l'état neuf ou par la capacité nominale de la cellule, qui peut être mémorisée dans le dispositif de gestion. Un inconvénient de ces techniques de détermination du SOH est qu'elles nécessitent la mise en oeuvre d'une décharge complète de la cellule suivie d'une recharge complète, ou d'une recharge complète suivie d'une décharge complète, ce qui est relativement contraignant.

La demande de brevet US2008/0150491 décrit une méthode permettant d'estimer la capacité réelle (et donc le SOH) d'une cellule à partir d'une recharge partielle de la cellule. La variation d'état de charge de la cellule nécessaire pour obtenir une estimation fiable de sa capacité réelle reste toutefois relativement élevée, ce qui peut poser problème dans certaines applications.

Les documents FR3011393, EP1263111, US2001/022518, JP2001257008, FR2977678, ainsi que l'article de Eddahech Akram et al. intitulé "Determination of lithium-ion battery state-of-health based on constant-voltage charge phase (Journal of Power Sources) décrivent d'autres exemples de méthodes permettant d'estimer le SOH d'une cellule.

Il serait souhaitable de pouvoir disposer d'une méthode de détermination du SOH d'une cellule de batterie, palliant tout ou partie des inconvénients des méthodes connues.

<u>Résumé</u>

Ainsi, un mode de réalisation prévoit un procédé de détermination de l'état de santé d'une cellule d'une batterie, mis en oeuvre par un dispositif électronique de diagnostic, comportant les étapes suivantes :

a) commander la recharge de la cellule selon un procédé de recharge de type CC-CV, comportant une phase CC de recharge de la cellule à courant constant, suivie d'une phase CV de recharge de la cellule à tension constante ;
b) pendant la phase CV, mesurer le courant de recharge I1 dans la cellule à un premier instant, mesurer le courant de recharge I2 dans la cellule à un deuxième instant postérieur au premier instant, et mesurer la variation de charge $\Delta Q$ de la cellule entre les premier et deuxième instants ;
c) calculer un coefficient $\alpha$ représentatif du rapport $\Delta Q/(I2-I1)$ ; et
d) déterminer une valeur SOH représentative de l'état de santé de la cellule en tenant compte du coefficient $\alpha$.

Selon un mode de réalisation, à l'étape d), la valeur SOH est déterminée à partir d'une fonction $g^{-1}$ telle que SOH=$g^{-1}(\alpha)$, déterminée au préalable lors d'une phase de caractérisation et mémorisée dans le dispositif électronique de diagnostic sous la forme d'une table correspondance ou d'une fonction analytique.

Selon un mode de réalisation, le procédé comporte en outre, avant l'étape a), une étape de mesure de l'état de charge initial $SOC_{init}$ de la cellule.

Selon un mode de réalisation, le procédé comprend en outre, entre l'étape a) et l'étape b), une étape de détection du passage de la phase CC à la phase CV de la recharge, une étape de mesure du courant de recharge $I_{CC}$ dans la cellule à l'instant de passage de la phase CC à la phase CV, et une étape de mesure de la quantité de charges $Q_{CC}$ injectée dans la cellule entre le début de la recharge et le passage de la phase CC à la phase CV.

Selon un mode de réalisation, le procédé comprend en outre, entre l'étape c) et l'étape d), une étape de calcul d'un coefficient $\beta$ représentatif de la différence $Q_{CC}-\alpha^{*}I_{CC}$.

Selon un mode de réalisation, le procédé comprend en outre, entre l'étape c) et l'étape d), une étape de calcul d'une valeur $C_{tot}$ représentative de la capacité réelle de la cellule, à partir des coefficients $\alpha$ et $\beta$ et de la valeur $SOC_{init}$ d'état de charge initial de la cellule.

Selon un mode de réalisation, la valeur $C_{tot}$ est calculée selon la formule :

$$C_{tot} = (\alpha * I_f + \beta) * 100 / (100 - SOC_{init}),$$

$I_f$ désignant une valeur prédéterminée du courant de fin de charge de la cellule.

Selon un mode de réalisation, la valeur SOH calculée à l'étape d) est représentative du rapport entre la valeur $C_{tot}$ et une valeur de référence $C_{nom}$ mémorisée dans le dispositif électronique de diagnostic, correspondant par exemple à la capacité nominale de la cellule ou à la capacité de la cellule à l'état neuf.

Un autre mode de réalisation prévoit une batterie électrique comportant une pluralité de cellules, et un dispositif électronique de diagnostic adapté à mettre en oeuvre un procédé de détermination de l'état de santé d'une cellule de la batterie tel que défini ci-dessus.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est un diagramme illustrant schématiquement la mise en oeuvre d'une recharge d'une cellule de batterie ;
la figure 2 est un diagramme illustrant l'évolution avec le vieillissement du comportement d'une cellule de batterie ;
la figure 3 est un diagramme illustrant l'évolution avec le vieillissement d'une valeur caractéristique d'une cellule de batterie ;
la figure 4 illustre, sous forme de blocs, un exemple d'un mode de réalisation d'un procédé de détermination de l'état de santé d'une cellule de batterie ;
la figure 5 illustre, sous forme de blocs, un exemple d'un autre mode de réalisation d'un procédé de détermination de l'état de santé d'une cellule de batterie ; et
la figure 6 représente très schématiquement une batterie électrique comportant un dispositif électronique de diagnostic adapté à mettre en oeuvre un procédé de détermination de l'état de santé d'une cellule de la batterie.

Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, la réalisation d'un dispositif électronique de gestion adapté à mettre en oeuvre les procédés de détermination du SOH proposés n'a pas été détaillée, la réalisation d'un tel dispositif étant à la portée de l'homme du métier à partir des indications fonctionnelles de la présente description. De plus, l'agencement et les schémas d'interconnexion des cellules d'une batterie n'ont pas été détaillés, les modes de réalisation décrits étant compatibles avec les agencements et schémas d'interconnexion usuels de cellules de batterie. Sauf précision contraire, les expressions "approximativement", "sensiblement", et "de l'ordre de" signifient à 10 % près, de préférence à 5 % près.

On s'intéresse ici plus particulièrement aux batteries dans lesquelles les cellules sont rechargées selon un procédé de recharge de type CC-CV, c'est-à-dire un procédé comportant une première phase de recharge dite à courant constant, ou phase CC, dans laquelle le courant de recharge appliqué à la cellule est sensiblement constant, suivie d'une deuxième phase de recharge dite à tension constante, ou phase CV, dans laquelle la tension appliquée à la cellule est sensiblement constante.

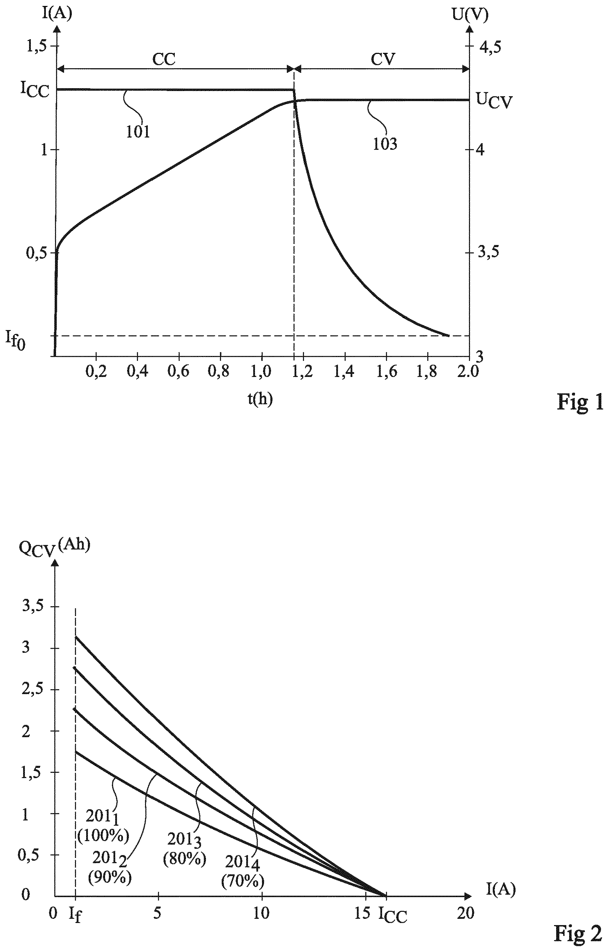

La figure 1 est un diagramme illustrant schématiquement l'évolution, en fonction du temps t (en heures (h), en abscisse), de la tension U (en volts (V), en ordonnée à droite) et du courant I (en ampères (A), en ordonnée à gauche) appliqués à une cellule de batterie pendant une recharge de type CC-CV.

Le diagramme de la figure 1 comprend plus particulièrement une courbe 101 représentant l'évolution du courant I en fonction du temps et une courbe 103 représentant l'évolution de la tension U en fonction du temps, pendant la recharge.

La recharge se divise en deux phases successives CC et CV. Lors de la phase CC, le courant de recharge I appliqué à la cellule (courbe 101) est sensiblement constant. On désigne ici par $I_{CC}$ la valeur du courant de recharge I pendant la phase CC. Pendant la phase CC, la tension U aux bornes de la cellule (courbe 103) croit au fur et à mesure que la cellule se charge, jusqu'à atteindre une valeur seuil $U_{CV}$, par exemple sensiblement égale à la tension nominale de pleine charge de la cellule. L'instant auquel la tension U de la cellule atteint la valeur $U_{CV}$ marque la fin de la phase CC et le début de la phase CV. A partir de cet instant la tension U appliquée aux bornes de la batterie reste sensiblement constante et égale à la valeur $U_{CV}$. Pendant la phase CV, le courant de recharge I traversant la cellule décroit au fur et à mesure que la cellule complète sa charge, jusqu'à atteindre une valeur seuil $I_f$. La valeur $I_f$ est une valeur basse prédéfinie en dessous de laquelle on considère que la recharge de la cellule est terminée. L'instant auquel le courant I atteint la valeur de fin de recharge $I_f$ marque la fin de la phase CV, et la fin de la recharge de la cellule.

En pratique, la mise en oeuvre d'une recharge de type CC-CV peut être contrôlée par le dispositif électronique de gestion de la batterie.

Les procédés de recharge de type CC-CV sont tout particulièrement adaptés à la recharge de cellules de type lithium-ion, mais peuvent être appliqués à d'autres types de cellules, par exemple à des cellules au plomb.

Les méthodes de détermination du SOH d'une cellule décrites ci-après s'appliquent aux cellules lithium-ion, et, plus généralement, à tous types de cellules compatibles avec un procédé de recharge de type CC-CV.

La figure 2 est un diagramme illustrant l'évolution, en fonction du vieillissement, du comportement d'une cellule de batterie pendant une recharge de type CC-CV de la cellule. La figure 2 comprend plus particulièrement quatre courbes $201_1$, $201_2$, $201_3$ et $201_4$, représentant respectivement l'évolution de la quantité de charges $Q_{CV}$ (en ampères heure (Ah), en ordonnée) injectée dans la cellule depuis le début de la phase CV, en fonction de l'intensité du courant I (en ampères (A), en abscisse) traversant la cellule, pour quatre états de vieillissement ou états de santé distincts de la cellule. Les courbes $201_1$, $201_2$, $201_3$ et $201_4$ de la figure 2 ont été tracées pour une cellule de type lithium-ion. On notera que les ordres de grandeur et échelles de courant des figures 1 et 2 sont différentes du fait que les figures 1 et 2 ont été tracées pour des cellules de dimensions différentes.

Les courbes $201_1$, $201_2$, $201_3$ et $201_4$ de la figure 2 correspondent respectivement à des états de vieillissement de plus en plus avancés de la cellule, c'est-à-dire à des SOH de plus en plus faibles. Plus particulièrement, dans cet exemple, les courbes $201_1$, $201_2$, $201_3$ et $201_4$ correspondent respectivement à des valeurs de SOH de l'ordre de 100 % (cellule à l'état neuf), 90 %, 80 % et 70 %.

Lors de la phase CV, la quantité de charges $Q_{CV}$ injectée dans la cellule croit progressivement au fur et à mesure que le courant I traversant la cellule décroit. Plus particulièrement, au début de la phase CV, la quantité de charges $Q_{CV}$ est nulle, tandis que le courant de recharge I traversant la cellule est sensiblement égal au courant de recharge $I_{CC}$ appliqué pendant la phase CC. Le courant I décroit ensuite de façon monotone, tandis que la quantité de charges $Q_{CV}$ croit de façon monotone jusqu'à atteindre une valeur finale $Q_{CVf}$ (non référencée sur la figure) lorsque le courant I atteint la valeur de fin de charge $I_f$.

Comme cela apparaît sur la figure, quel que soit le SOH de la cellule, l'évolution de la quantité de charges $Q_{CV}$ en fonction du courant I traversant la cellule au cours de la phase CV est sensiblement linéaire. On assimile ici la fonction f telle que $Q_{CV} = f(I)$ à une fonction linéaire d'équation $Q_{CV} = \alpha * I + \beta$ pendant la phase CV, c'est-à-dire pour I allant de $I_f$ à $I_{CC}$. La valeur $\alpha$ est un coefficient négatif désignant la pente de la fonction f, et la valeur $\beta$ désigne l'ordonnée à l'origine de la fonction f, c'est-à-dire la valeur finale $Q_{CVf}$ de la quantité de charges $Q_{CV}$ en fin de recharge, c'est-à-dire pour $I=I_f$.

On constate sur la figure 2 que plus le SOH de la cellule est faible, plus la pente $\alpha$, en valeur absolue, est élevée. De plus, plus le SOH de la cellule est faible, plus l'ordonnée à l'origine $\beta = Q_{CVf}$ est élevée. Autrement dit, plus le SOH de la cellule est faible, plus la quantité totale de charges $Q_{CVf}$ injectée dans la cellule pendant la phase CV est élevée, et plus la quantité de charges $Q_{CV}$ injectée dans la cellule pendant la phase CV croit rapidement avec la diminution du courant I traversant la cellule.

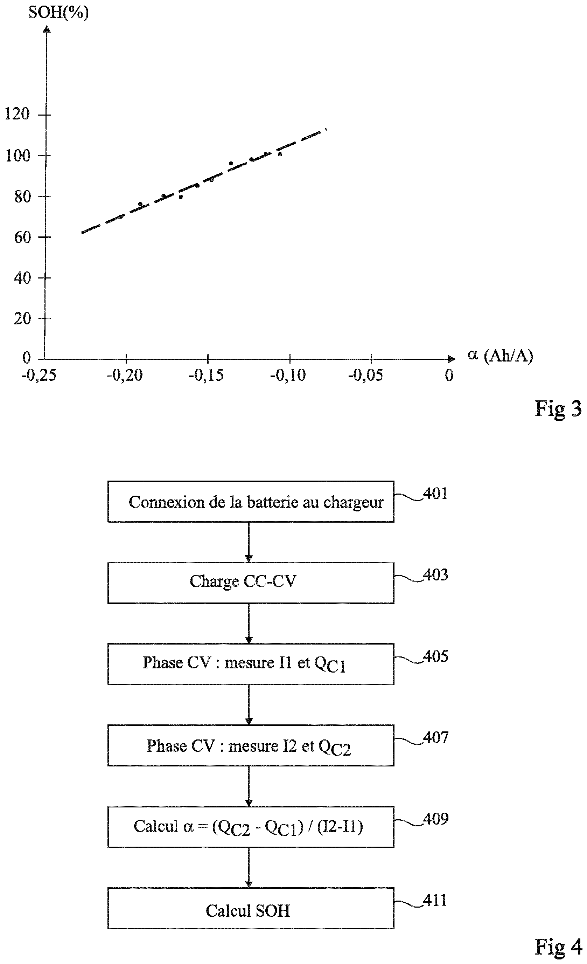

La figure 3 est un diagramme illustrant l'évolution, en fonction du SOH (en pourcents (%), en ordonnée), du coefficient $\alpha$ (en ampères heure par ampère (Ah/A), en abscisse) de la cellule.

Comme cela apparaît sur la figure 3, dans cet exemple, le coefficient négatif $\alpha$ croit de façon sensiblement linéaire avec le SOH, avec, dans l'exemple représenté, une valeur de l'ordre de $\alpha=-0,20$ pour un SOH de 70 % et une valeur de l'ordre de $\alpha=-0,10$ pour un SOH de l'ordre de 100 %.

Plus généralement, les inventeurs ont constaté que pour toute cellule de batterie compatible avec un procédé de recharge de type CC-CV, le coefficient négatif $\alpha$ de la cellule constitue une valeur caractéristique de la cellule, qui croit de façon monotone avec le SOH de la cellule selon une fonction g telle que $\alpha$=g(SOH).

Selon un aspect d'un mode de réalisation, on prévoit, pour estimer le SOH d'une cellule, de mesurer, pendant la phase CV d'une recharge de la cellule, une valeur représentative du coefficient $\alpha$ de la cellule, puis de calculer le SOH de la cellule en tenant compte du coefficient $\alpha$ mesuré.

La figure 4 illustre, sous forme de blocs, des étapes d'un exemple d'un mode de réalisation d'un procédé de détermination du SOH d'une cellule de batterie. Ce procédé est par exemple mis en oeuvre par un dispositif électronique de gestion (non détaillé) intégré à la batterie. Le dispositif électronique de gestion peut notamment comporter des circuits de mesure de la tension U aux bornes des différentes cellules de la batterie, des circuits de mesure du courant I à travers les différentes cellules de la batterie, des circuits de mesure et d'intégration de la quantité de charges injectée dans les différentes cellules de la batterie pendant une phase de recharge, et des circuits de traitement et de calcul, par exemple de type microprocesseur.

Lors d'une étape initiale 401, le dispositif de gestion détecte la connexion de la batterie à un chargeur.

Lors d'une étape 403 qui fait suite à la détection de la connexion de la batterie à un chargeur à l'étape 401, le dispositif de gestion commande la recharge de la cellule selon un procédé de recharge de type CC-CV.

Lors d'une étape 405, à un instant t1 de la phase CV de la recharge démarrée à l'étape 403, le dispositif de gestion mesure la valeur I1 du courant de recharge I traversant la cellule, et mesure en outre la quantité de charges $Q_{C1}$ injectée dans la cellule depuis le début de la recharge démarrée à l'étape 403.

Lors d'une étape 407, à un instant t2 de la phase CV postérieur à l'instant t1, le dispositif de gestion mesure la valeur I2 du courant de recharge I traversant la cellule, et mesure en outre la quantité de charges $Q_{C2}$ injectée dans la cellule depuis le début de la recharge démarrée à l'étape 403.

Lors d'une étape 409 postérieure à l'étape 407, le dispositif de gestion calcule, à partir des mesures de courant et de quantités de charges injectées réalisées aux étapes 405 et 407, une valeur $\alpha$ représentative de la pente de l'approximation linéaire de la courbe représentative de l'évolution de la charge en fonction du courant I pendant la phase CV de la recharge de la cellule, par exemple selon la formule $\alpha = (Q_{C2}-Q_{C1})/(I2-I1)$.

Lors d'une étape 411 postérieure à l'étape 409, le dispositif de gestion détermine une valeur représentative du SOH de la cellule en tenant compte du coefficient $\alpha$ calculé à l'étape 409. Pour cela, la fonction $g^{-1}$ telle que SOH= $g^{-1}(\alpha)$ peut être mémorisée dans le dispositif de gestion de la batterie, par exemple sous la forme d'une table de correspondances, ou sous la forme d'une fonction analytique.

La fonction $g^{-1}$ est par exemple déterminée lors d'une phase préalable de caractérisation à partir d'une cellule de référence de même type que les cellules de la batterie, au cours de laquelle on mesure le coefficient $\alpha$ pour différents états de vieillissement de la cellule de référence.

On notera que les modes de réalisation décrits ne se limitent pas à l'exemple particulier illustré par la figure 3 dans lequel la fonction g, et donc la fonction réciproque $g^{-1}$, sont des fonctions linéaires. Plus généralement, les modes de réalisation décrits s'appliquent quelle que soit la forme de la fonction $g^{-1}$, pour autant qu'il s'agisse d'une fonction monotone.

Un avantage du mode de réalisation de la figure 4 est qu'il permet de déterminer le SOH d'une cellule à partir d'une courte période de la recharge de la cellule. En effet, dans la mesure où la courbe représentative de l'évolution de la quantité de charges injectée en fonction du courant de recharge pendant la phase CV peut être assimilée à une droite (figure 2), les instants t1 de mesure du courant I1 et de la quantité de charges injectée $Q_{C1}$ (étape 405) et t2 de mesure du courant du courant I2 et de la quantité de charges injectée $Q_{C2}$ (étape 407) peuvent être relativement rapprochés. A titre d'exemple, l'intervalle de temps séparant les instants t1 et t2 peut être inférieur à 5 minutes, par exemple inférieur à 2 minutes, ce qui permet d'obtenir rapidement une estimation du SOH de la cellule, sans avoir à réaliser une recharge complète de la cellule.

En particulier, le procédé de la figure 4 peut être appliqué même si le niveau de charge de la cellule au moment de la connexion de la batterie au chargeur est tel que la recharge commandée à l'étape 403 démarre directement dans la phase CV, c'est-à-dire tel que la tension U aux bornes de la cellule soit déjà égale à la valeur $U_{CV}$ appliquée à la cellule pendant la phase CV, à condition toutefois que la cellule ne soit pas déjà totalement chargée (c'est-à-dire à condition que le courant I dans la cellule au début de la recharge soit supérieur au courant de fin de charge $I_f$).

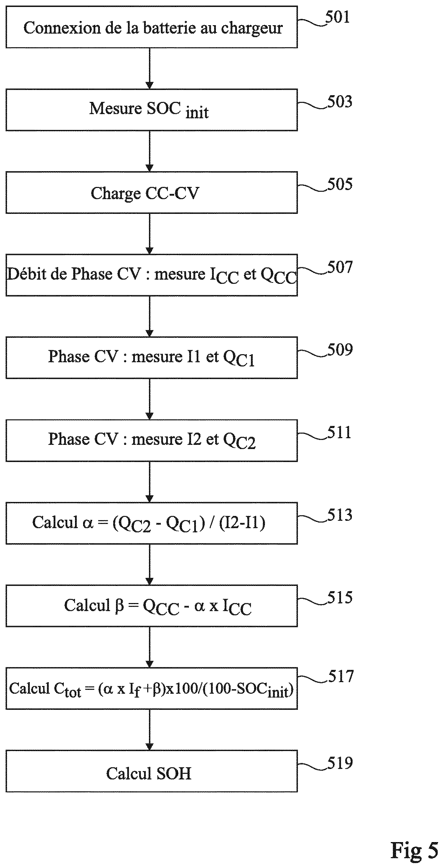

La figure 5 illustre, sous forme de blocs, des étapes d'un exemple d'un autre mode de réalisation d'un procédé de détermination du SOH d'une cellule de batterie. Comme pour l'exemple de la figure 4, ce procédé peut être mis en oeuvre par un dispositif électronique de gestion intégré à la batterie.

Lors d'une étape initiale 501, le dispositif de gestion détecte la connexion de la batterie à un chargeur.

Lors d'une étape 503 qui fait suite à la détection de la connexion de la batterie à un chargeur à l'étape 501, le dispositif de gestion mesure et mémorise l'état de charge initial $SOC_{init}$ de la cellule. A titre d'exemple, à l'étape 503, l'état de charge initial $SOC_{init}$ est déterminé à partir d'une mesure de la tension à vide, ou tension en circuit ouvert de la cellule. Plus généralement, toute autre méthode de détermination de l'état de charge d'une cellule peut être utilisée.

Lors d'une étape 505 postérieure à l'étape 503, le dispositif de gestion commande la recharge de la cellule selon un procédé de recharge de type CC-CV.

Lors d'une étape 507, le dispositif de gestion détecte la fin de la phase CC et le début de la phase CV de la recharge démarrée à l'étape 505, et mesure à cet instant la valeur $I_{CC}$ du courant de recharge I traversant la cellule (correspondant au courant appliqué à la cellule pendant la phase CC), et la quantité de charges $Q_{CC}$ injectée dans la cellule depuis le début de la recharge.

Lors d'une étape 509 postérieure à l'étape 507, à un instant t1 de la phase CV de la recharge démarrée à l'étape 505, le dispositif de gestion mesure la valeur I1 du courant de recharge I traversant la cellule, et mesure en outre la quantité de charges $Q_{C1}$ injectée dans la cellule depuis le début de la recharge démarrée à l'étape 505.

Lors d'une étape 511, à un instant t2 de la phase CV postérieur à l'instant t1, le dispositif de gestion mesure la valeur I2 du courant de recharge I traversant la cellule, et mesure en outre la quantité de charges $Q_{C2}$ injectée dans la cellule depuis le début de la recharge démarrée à l'étape 505.

Lors d'une étape 513 postérieure à l'étape 511, le dispositif de gestion calcule, à partir des mesures de courant et de quantités de charges injectées réalisées aux étapes 509 et 511, une valeur $\alpha$ représentative de la pente de l'approximation linéaire de la courbe représentative de l'évolution de la charge en fonction du courant I pendant la phase CV de la recharge de la cellule, par exemple selon la formule $\alpha = (Q_{C2}-Q_{C1})/(I2-I1)$.

Lors d'une étape 515 postérieure à l'étape 513, le dispositif de gestion calcule, à partir de la valeur $\alpha$ déterminée à l'étape 513 et des mesures de courant et de quantité de charges réalisée à l'étape 507, une valeur $\beta$ représentative de l'ordonnée à l'origine de l'approximation linéaire de la courbe représentative de l'évolution de la charge en fonction du courant I pendant la phase CV de la recharge de la cellule, par exemple selon la formule $\beta = Q_{CC}-\alpha*I_{CC}$.

Lors d'une étape 517 postérieure à l'étape 515, le dispositif de gestion calcule une valeur extrapolée $C_{tot}$ représentative de la capacité totale réelle de la cellule, à partir des valeurs $\alpha$ et $\beta$ déterminées aux étapes 513 et 515 et de la valeur d'état de charge initial $SOC_{init}$ déterminée à l'étape 503, par exemple selon la formule $C_{tot} = (\alpha*I_f + \beta)*100/(100-SOC_{init})$.

Lors d'une étape 519 postérieure à l'étape 517, le dispositif de gestion peut calculer le SOH de la cellule à partir de la capacité $C_{tot}$ déterminée à l'étape 517, par exemple selon la formule $SOH = (C_{tot}/C_{nom})*100$, où $C_{nom}$ est une valeur de capacité de référence mémorisée par le dispositif de gestion, correspondant par exemple à la capacité nominale de la cellule, ou à sa capacité réelle mesurée à l'état neuf.

Par rapport au mode de réalisation de la figure 4, un avantage du mode de réalisation de la figure 5 est qu'il permet d'obtenir une estimation plus précise du SOH de la cellule. En contrepartie, le procédé de la figure 5 requiert, pour sa mise en oeuvre, une période de recharge plus longue de la cellule, puisque la recharge doit commencer dans la phase CC (l'étape 507 de mesure du courant $I_{CC}$ et de la charge $Q_{CC}$ étant mise en oeuvre au passage de la phase CC à la phase CV), et se poursuivre pendant au moins une partie de la phase CV (les étapes successives 509 et 511 étant mises en oeuvre pendant la phase CC).

Pour améliorer la précision de la détermination du SOH, le calcul de la capacité $C_{tot}$ à l'étape 517 du procédé de la figure 5 peut tenir compte du rendement faradique Rf de la cellule, c'est-à-dire du rapport de la quantité de charges effectivement disponible en décharge sur la quantité de charges injectée dans la cellule pendant la recharge. A titre d'exemple, la capacité $C_{tot}$ peut être calculée selon la formule $C_{tot} = ((\alpha*I_f + \beta)*100/(100-SOC_{init}))*Rf$. En pratique, pour les cellules lithium-ion, le rendement faradique est généralement de l'ordre de 1 et peut donc être négligé.

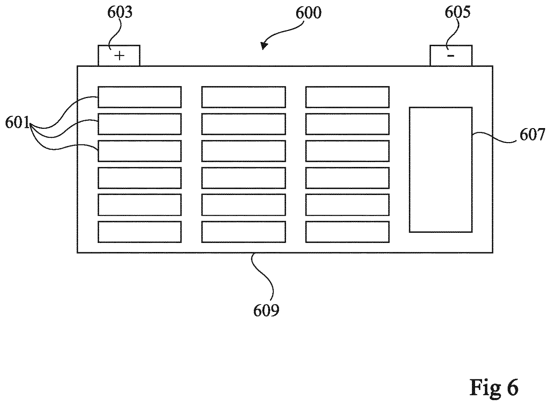

La figure 6 représente très schématiquement une batterie électrique 600 comportant une pluralité de cellules de stockage 601 interconnectées en série et/ou en parallèle entre une borne positive 603 et une borne négative 605 de la batterie. Par souci de simplification, les interconnexions des cellules 601, et les connexions des cellules 601 aux bornes 603 et 605 n'ont pas été représentées sur la figure 6.

La batterie 600 comprend un dispositif électronique de diagnostic 607 connecté aux cellules 601 de la batterie et adapté à mettre en oeuvre un procédé de détermination du SOH d'une cellule du type décrit ci-dessus en relation avec les figures 4 ou 5. Par souci de simplification, les connexions du dispositif électronique de diagnostic 607 aux cellules 601 n'ont pas été représentées sur la figure 6. Le dispositif de diagnostic 607 fait par exemple partie d'un dispositif électronique de gestion de la batterie adapté à mettre en oeuvre d'autres fonctions telles que des fonctions de protection, d'équilibrage, etc.

Dans cet exemple, le dispositif de diagnostic 607 et les cellules 601 sont disposés dans un même boîtier de protection 609 de la batterie, laissant accessible les bornes 603 et 605 pour permettre de connecter la batterie à un dispositif extérieur tel qu'une charge à alimenter ou un chargeur.

Des modes de réalisation particuliers ont été décrits. Diverses variantes et modifications apparaîtront à l'homme de l'art. En particulier, les modes de réalisation décrits ne se limitent pas aux exemples susmentionnés dans lesquels le procédé de détermination du SOH de la cellule est mis en oeuvre par un dispositif électronique intégré à la batterie. A titre de variante, les procédés décrits ci-dessus peuvent être mis en oeuvre par un dispositif électronique de diagnostic externe à la batterie. A titre d'exemple, la cellule dont on souhaite mesurer le SOH peut être extraite de la batterie pour réaliser la mesure du SOH au moyen d'un dispositif de diagnostic externe.

En outre, les procédés décrits ci-dessus peuvent être appliqués soit à une cellule élémentaire unique d'une batterie, soit à un sous-ensemble de plusieurs cellules interconnectées de la batterie, soit à la batterie complète. Ainsi, par cellule de batterie, on entend ici de façon générale tout élément rechargeable de stockage d'énergie électrique, par exemple une cellule élémentaire unique d'une batterie, ou un sous-ensemble de plusieurs cellules élémentaires interconnectées d'une batterie, ou encore une batterie complète.

## Revendications

1. Procédé de détermination de l'état de santé d'une cellule d'une batterie, mis en oeuvre par un dispositif électronique de diagnostic, comportant les étapes suivantes :

   a) commander la recharge de la cellule selon un procédé de recharge de type CC-CV, comportant une phase CC de recharge de la cellule à courant constant, suivie d'une phase CV de recharge de la cellule à tension constante ; et
   b) pendant la phase CV, mesurer le courant de recharge I1 dans la cellule à un premier instant, et mesurer le courant de recharge I2 dans la cellule à un deuxième instant postérieur au premier instant,

   **caractérisé en ce que**, à l'étape b), la variation de charge $\Delta Q$ de la cellule entre les premier et deuxième instants est mesurée, et **en ce qu'**il comprend en outre les étapes suivantes :

   c) calculer un coefficient $\alpha$ représentatif du rapport $\Delta Q/(I2-I1)$ ; et
   d) déterminer une valeur SOH représentative de l'état de santé de la cellule en tenant compte du coefficient $\alpha$.

2. Procédé selon la revendication 1, dans lequel, à l'étape d), la valeur SOH est déterminée à partir d'une fonction $g^{-1}$ telle que SOH=$g^{-1}(\alpha)$, déterminée au préalable lors d'une phase de caractérisation et mémorisée dans le dispositif électronique de diagnostic sous la forme d'une table de correspondance ou d'une fonction analytique.

3. Procédé selon la revendication 1, comportant en outre, avant l'étape a), une étape (503) de mesure de l'état de charge initial $SOC_{init}$ de la cellule.

4. Procédé selon la revendication 3, comprenant en outre, entre l'étape a) et l'étape b), une étape de détection du passage de la phase CC à la phase CV de la recharge, une étape de mesure du courant de recharge $I_{CC}$ dans la cellule à l'instant de passage de la phase CC à la phase CV, et une étape de mesure de la quantité de charges $Q_{CC}$ injectée dans la cellule entre le début de la recharge et le passage de la phase CC à la phase CV.

5. Procédé selon la revendication 4, comprenant en outre, entre l'étape c) et l'étape d), une étape de calcul d'un coefficient $\beta$ représentatif de la différence $Q_{CC}-\alpha*I_{CC}$.

6. Procédé selon la revendication 5, comprenant en outre, entre l'étape c) et l'étape d), une étape de calcul d'une valeur $C_{tot}$ représentative de la capacité réelle de la cellule, à partir des coefficients $\alpha$ et $\beta$ et de la valeur $SOC_{init}$ d'état de charge initial de la cellule.

7. Procédé selon la revendication 6, dans lequel la valeur $C_{tot}$ est calculée selon la formule :

$$C_{tot} = (\alpha*I_f + \beta)*100/(100-SOC_{init}),$$

   $I_f$ désignant une valeur prédéterminée du courant de fin de charge de la cellule.

8. Procédé selon la revendication 6 ou 7, dans lequel la valeur SOH calculée à l'étape d) est représentative du rapport entre la valeur $C_{tot}$ et une valeur de référence $C_{nom}$ mémorisée dans le dispositif électronique de diagnostic, correspondant par exemple à la capacité nominale de la cellule ou à la capacité de la cellule à l'état neuf.

9. Batterie électrique (600) comportant une pluralité de cellules (601), et un dispositif électronique de diagnostic (607) adapté à mettre en oeuvre un procédé de détermination de l'état de santé d'une cellule (601) de la batterie (600) selon l'une quelconque des revendications 1 à 8.

**Patentansprüche**

1. Ein Verfahren zum Bestimmen des Gesundheitszustands einer Batteriezelle, implementiert durch eine elektronische Diagnosevorrichtung, das die folgenden Schritte aufweist:

   a) Steuern des Aufladens der Zelle gemäß einem CC-CV-Aufladeverfahren, das eine Phase CC des Zellenaufladens mit konstantem Strom aufweist, gefolgt von einer Phase CV des Zellenaufladens mit konstanter Spannung; und
   b) während der Phase CV Messen des Aufladestroms I1 in der Zelle zu einem ersten Zeitpunkt und Messen des Aufladestroms I2 in der Zelle zu einem zweiten Zeitpunkt nach dem ersten Zeitpunkt,

   **dadurch gekennzeichnet, dass** im Schritt b) die Ladeschwankung $\Delta Q$ der Zelle zwischen dem ersten und zweiten Zeitpunkt gemessen wird, und dass es ferner die folgenden Schritte aufweist:

   c) Berechnen eines Koeffizienten $\alpha$, der für das Verhältnis $\Delta Q / (I2-I1)$ repräsentativ ist; und
   d) Bestimmen eines Wertes SOH, der für den Gesundheitszustand der Zelle repräsentativ ist unter Berücksichtigung des Koeffizienten $\alpha$.

2. Verfahren nach Anspruch 1, wobei in Schritt d) der Wert SOH aus einer Funktion $g^{-1}$ ermittelt wird, so dass SOH=$g^{-1}$($\alpha$) zuvor während einer Charakterisierungsphase bestimmt wurde und in der elektronischen Diagnosevorrichtung in Form einer Nachschlagetabelle oder einer analytischen Funktion gespeichert wurde.

3. Verfahren nach Anspruch 1, das ferner vor Schritt a) einen Schritt (503) des Messens des Anfangszustands der Aufladung $SOC_{init}$ der Zelle aufweist.

4. Verfahren nach Anspruch 3, das ferner zwischen Schritt a) und Schritt b) einen Schritt des Detektierens des Umschaltens von Phase CC zu Phase CV des Aufladens, einen Schritt des Messens des Aufladestroms $I_{CC}$ in der Zelle zu dem Zeitpunkt des Umschaltens von der Phase CC zu der Phase CV und einem Schritt des Messens der Menge an Ladungen Qcc, die in die Zelle zwischen dem Beginn des Aufladens und dem Umschalten von der Phase CC zu der Phase CV injiziert werden, aufweist.

5. Verfahren nach Anspruch 4, das ferner zwischen Schritt c) und Schritt d) einen Schritt des Berechnens eines Koeffizienten $\beta$, der für die Differenz Qcc-$\alpha$*$I_{CC}$ repräsentativ ist, aufweist.

6. Verfahren nach Anspruch 5, das ferner zwischen Schritt c) und Schritt d) einen Schritt des Berechnens eines Wertes $C_{tot}$ aufweist, der die tatsächliche Kapazität der Zelle repräsentiert, aus den Koeffizienten $\alpha$ und $\beta$ und aus dem Wert $SOC_{init}$ des Anfangszustands der Ladung der Zelle.

7. Verfahren nach Anspruch 6, wobei der Wert $C_{tot}$ gemäß der folgenden Formel berechnet wird:

$$C_{tot} = (\alpha{*}I_f + \beta) {*}100/ (100-SOC_{init}),$$

wobei $I_f$ einen vorbestimmten Wert des Endes des Ladensstroms der Zelle anzeigt.

8. Verfahren nach Anspruch 6 oder 7, wobei der in Schritt d) berechnete Wert SOH repräsentativ für das Verhältnis zwischen dem Wert $C_{tot}$ und einem Referenzwert $C_{nom}$ ist, der in der elektronischen Diagnosevorrichtung gespeichert ist und beispielsweise mit der Nennkapazität der Zelle oder der Kapazität der Zelle in neuem Zustand korrespondiert.

9. Eine elektrische Batterie (600), die eine Vielzahl von Zellen (601) aufweist, und eine elektronische Diagnosevorrichtung (607), die geeignet ist zum Implementieren eines Verfahrens zum Bestimmen des Gesundheitszustands einer Zelle (601) der Batterie (600) nach einem der Ansprüche 1 bis 8.

**Claims**

1. A method of determining the state of health of a battery cell, implemented by an electronic diagnosis device, comprising the steps of:

a) controlling the recharge of the cell according to a CC-CV recharge method, comprising a phase CC of cell recharge at constant current, followed by a phase CV of cell recharge at constant voltage; and

b) during phase CV, measuring the recharge current I1 in the cell at a first time, and measuring the recharge current 12 in the cell at a second time subsequent to the first time,

**characterized in that**, at step b), the charge variation $\Delta Q$ of the cell between the first and second times is measured, and **in that** it further comprises the steps of:

c) calculating a coefficient $\alpha$ representative of ratio $\Delta Q/(I2-I1)$; and

d) determining a value SOH representative of the state of health of the cell by taking into account coefficient $\alpha$.

2. The method of claim 1, wherein, at step d), value SOH is measured from a function $g^{-1}$ such that $SOH = g^{-1}(\alpha)$, previously determined during a characterization phase and stored in the electronic diagnosis device in the form of a look-up table or of an analytic function.

3. The method of claim 1, further comprising, before step a), a step (503) of measurement of the initial stage of charge $SOC_{init}$ of the cell.

4. The method of claim 3, further comprising, between step a) and step b), a step of detection of the switching from phase CC to phase CV of the recharge, a step of measurement of recharge current $I_{CC}$ in the cell at the time of the switching from phase CC to phase CV, and a step of measurement of the quantity of charges $Q_{CC}$ injected into the cell between the beginning of the recharge and the switching from phase CC to phase CV.

5. The method of claim 4, further comprising, between step c) and step d), a step of calculation of a coefficient $\beta$ representative of difference $Q_{CC} - \alpha * I_{CC}$.

6. The method of claim 5, further comprising, between step c) and step d), a step of calculation of a value $C_{tot}$ representative of the real capacity of the cell, from coefficients $\alpha$ and $\beta$ and from value $SOC_{init}$ of the initial state of charge of the cell.

7. The method of claim 6, wherein value $C_{tot}$ is calculated according to formula:

$$C_{tot} = (\alpha * I_f + \beta) * 100 / (100 - SOC_{init}),$$

with $I_f$ designating a predetermined value of the end-of-charge current of the cell.

8. The method of claim 6 or 7, wherein the value SOH calculated at step d) is representative of the ratio of value $C_{tot}$ to a reference value $C_{nom}$ stored in the electronic diagnosis device, for example corresponding to the nominal capacity of the cell or to the capacity of the cell when new.

9. An electric battery (600) comprising a plurality of cells (601) and an electronic diagnosis device (607) capable of implementing a method of determining the state of health of a cell (601) of the battery (600) of any of claims 1 to 8.

Fig 1

Fig 2

SOH(%)

Fig 3

Fig 4

```
┌─────────────────────────────────────────┐
│   Connexion de la batterie au chargeur   │─── 501
└─────────────────────────────────────────┘
                    │
                    ▼
┌─────────────────────────────────────────┐
│              Mesure SOC init             │─── 503
└─────────────────────────────────────────┘
                    │
                    ▼
┌─────────────────────────────────────────┐
│              Charge CC-CV                │─── 505
└─────────────────────────────────────────┘
                    │
                    ▼
┌─────────────────────────────────────────┐
│  Débit de Phase CV : mesure ICC et QCC   │─── 507
└─────────────────────────────────────────┘
                    │
                    ▼
┌─────────────────────────────────────────┐
│        Phase CV : mesure I1 et QC1       │─── 509
└─────────────────────────────────────────┘
                    │
                    ▼
┌─────────────────────────────────────────┐
│        Phase CV : mesure I2 et QC2       │─── 511
└─────────────────────────────────────────┘
                    │
                    ▼
┌─────────────────────────────────────────┐
│   Calcul α = (QC2 - QC1) / (I2-I1)       │─── 513
└─────────────────────────────────────────┘
                    │
                    ▼
┌─────────────────────────────────────────┐
│       Calcul β = QCC - α x ICC           │─── 515
└─────────────────────────────────────────┘
                    │
                    ▼
┌─────────────────────────────────────────┐
│ Calcul Ctot = (α x If +β)x100/(100-SOCinit) │─── 517
└─────────────────────────────────────────┘
                    │
                    ▼
┌─────────────────────────────────────────┐
│              Calcul SOH                  │─── 519
└─────────────────────────────────────────┘
```

Étapes :

- $501$ : Connexion de la batterie au chargeur
- $503$ : Mesure $SOC_{init}$
- $505$ : Charge CC-CV
- $507$ : Débit de Phase CV : mesure $I_{CC}$ et $Q_{CC}$
- $509$ : Phase CV : mesure $I1$ et $Q_{C1}$
- $511$ : Phase CV : mesure $I2$ et $Q_{C2}$
- $513$ : Calcul $\alpha = (Q_{C2} - Q_{C1}) / (I2-I1)$
- $515$ : Calcul $\beta = Q_{CC} - \alpha \times I_{CC}$
- $517$ : Calcul $C_{tot} = (\alpha \times I_f + \beta) \times 100/(100-SOC_{init})$
- $519$ : Calcul SOH

**Fig 5**

Fig 6

**EP 3 324 197 B1**

## RÉFÉRENCES CITÉES DANS LA DESCRIPTION

**Documents brevets cités dans la description**

- US 20080150491 A
- FR 3011393
- EP 1263111 A
- US 2001022518 A
- JP 2001257008 B
- FR 2977678